(19) Europäisches Patentamt
European Patent Office
Office européen des brevets

(11) **EP 3 341 322 B1**

(12) **EUROPEAN PATENT SPECIFICATION**

(45) Date of publication and mention
of the grant of the patent:
**07.10.2020 Bulletin 2020/41**

(21) Application number: **15902420.7**

(22) Date of filing: **25.08.2015**

(51) Int Cl.:
*B81B 1/00* (2006.01)   *G03F 7/00* (2006.01)
*B82Y 20/00* (2011.01)   *E04C 3/28* (2006.01)
*E04B 5/48* (2006.01)   *E04B 5/02* (2006.01)
*G02B 6/12* (2006.01)   *B81C 1/00* (2006.01)
*B33Y 10/00* (2015.01)   *B33Y 80/00* (2015.01)
*B82Y 30/00* (2011.01)

(86) International application number:
**PCT/US2015/046771**

(87) International publication number:
**WO 2017/034553 (02.03.2017 Gazette 2017/09)**

(54) **SPARSE TRUSS STRUCTURES AND METHODS OF MAKING THE SAME**

SPÄRLICHE FACHWERKSTRUKTUREN UND VERFAHREN ZUR HERSTELLUNG DAVON

STRUCTURES EN TREILLIS ÉPARS ET PROCÉDÉS DE FABRICATION DE CES DERNIÈRES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**04.07.2018 Bulletin 2018/27**

(73) Proprietor: HRL Laboratories LLC
Malibu, CA 90265-4797 (US)

(72) Inventors:
• **CLOUGH, Eric, C.**
Santa Monica, CA 90404 (US)
• **ENSBERG, Jie**
Sherman Oaks, CA 91411 (US)
• **JACOBSEN, Alan, J.**
Woodland Hills, CA 91364 (US)
• **HUNDLEY, Jacob, M.**
Newbury Park, CA 91320 (US)
• **CARTER, William**
Calabasas, CA 91302 (US)
• **SCHAEDLER, Tobias, A.**
Oak Park, CA 91377 (US)

(74) Representative: **Gulde & Partner
Patent- und Rechtsanwaltskanzlei mbB
Wallstraße 58/59
10179 Berlin (DE)**

(56) References cited:
WO-A1-2008/078883   US-A1- 2010 236 759
US-A1- 2012 244 475   US-A1- 2013 143 060
US-A1- 2014 272 275   US-A1- 2015 017 383
US-A1- 2015 176 132   US-B1- 8 921 702

• Lyle Matthew Gordon: "Hybrid Nanocrystalline Mesoscale Periodic Cellular Materials", , 1 March 2008 (2008-03-01), pages 1-88, XP055577202, Retrieved from the Internet: URL:https://www.researchgate.net/publication/259739722_Hybrid_Nanocrystalline_Mesoscale_Periodic_Cellular_Materials* [retrieved on 2019-04-03]

**Description**

FIELD

The present disclosure relates generally to micro-truss structures and, more particularly, to sparse micro-truss structures.

BACKGROUND

Structural components commonly include a pair of rigid facesheets separated by a lightweight core. The lightweight core may be either a closed-cell material, such as honeycomb or closed-cell foam, or an open-cell configuration, such as a lattice or truss structure. However, structural elements with truss cores may tend to suffer from buckling failure due to the relatively high aspect ratios of individual struts within the truss core.

Additionally, related art truss cores typically include an interconnected network of ordered struts. However, the interconnectedness of related art truss structures makes the structure more susceptible to premature failure due to manufacturing defects in one or more of the struts. For instance, one or more of the struts in a related art truss structure may include a manufacturing defect that causes premature buckling or bending deformation of those defective struts and the premature failure of those defective struts may, in turn, lead to the failure of the overall structure. Accordingly, truss structures with an ordered arrangement of interconnected struts have an increased sensitivity to the premature failure of the one or more defective struts within the truss structure.

Exemplary embodiments of micro-struss structures of the prior art are disclosed in US 2015/017383 A1, WO 2008/078883 A1, and US 2010/236759 A1.

Additionally, related art truss structures may increase the strut diameter and/or alter the angle of the struts to compensate for anticipated manufacturing defects in the struts. However, increasing the diameter of the struts increases the overall weight of the structure and altering the strut angles trades off between compression strength and shear strength of the structure.

SUMMARY

The present invention is directed to a micro-truss structure matter as defined in claim 1, and to a method of manufacturing said micro-truss structure as defined in claim 7. Preferred embodiments are defined by the dependent claims.

The present disclosure is directed to various embodiments of a micro-truss structure. In one aspect, the micro-truss structure includes a series of unit cells arranged in an array. Each of the unit cells includes a series of struts interconnected at a node. At least two adjacent unit cells are spaced apart by a gap. The array may be rectilinear. The series of unit cells may include a first series of unit cells arranged in a first row of the array and a second series of unit cells arranged in a second row of the array. The array may be a staggered array and the second series of unit cells in the second row of the array may be laterally offset from the first series of unit cells in the first row of the array. At least one of the struts in each of the first series of unit cells in the first row may be interconnected to one of the struts in one of the second series of unit cells in the second row. The second series of unit cells in the second row of the array may be aligned with the first series of unit cells in the first row of the array, and each of the second series of unit cells may be spaced apart by a gap from a corresponding unit cell of the first series of unit cells. The struts may be solid or hollow. The struts in each of the unit cells may be arranged in a square base pyramid configuration or a triangular base pyramid configuration. The micro-truss structure may also include a first facesheet coupled to the node of each of the unit cells and a second facesheet coupled to ends of the struts. The unit cells may be half unit cells or full unit cells. The struts may be made out of any suitable material, such as polymer, metal, metal alloy, ceramic, or any combination thereof. The length of the struts, the diameter of the struts, the spacing between the nodes, and/or the height of the unit cells may vary across the micro-truss structure.

The present disclosure is also directed to various methods of manufacturing a micro-truss structure. In one aspect, the method includes irradiating a volume of photo-monomer with a series of light beams to form a series of unit cells arranged in an array. Each of the unit cells includes a series of polymer optical waveguides interconnected at a node. At least two adjacent unit cells are spaced apart by a gap. The light beams may be directed through a series of apertures defined in a mask and the apertures in the mask may be arranged in either an aligned array or a staggered array. The method may also include coupling a first facesheet to the node of each of the unit cells and coupling a second facesheet to ends of the polymer optical waveguides. The method may also include coating the polymer optical waveguides with a dissimilar material by any suitable process, such as electrodeposition, electroplating, vapor deposition, spray coating, dip coating, or any combination thereof. The method may also include selectively removing the polymer optical waveguides to form a plurality of interconnected hollow tubular struts formed out of the dissimilar material coated onto the polymer optical waveguides. The method may also include orienting the light beams such that the polymer optical waveguides in each of the unit cells are arranged in a square base pyramid configuration or a triangular base pyramid configuration.

This summary is provided to introduce a selection of concepts that are further described below in the detailed description. The scope of the invention is defined by the appended claims.

BRIEF DESCRIPTION OF THE DRAWINGS

These and other features and advantages of embodiments of the present disclosure will become more apparent by reference to the following detailed description when considered in conjunction with the following drawings. In the drawings, like reference numerals are used throughout the figures to reference like features and components. The figures are not necessarily drawn to scale.

FIGS. 1A and 1B are a perspective view and a side view, respectively, of a sparse micro-truss structure according to one embodiment of the present disclosure;

FIGS. 2A and 2B are a perspective view and a side view, respectively, of a sparse micro-truss structure according to another embodiment of the present disclosure;

FIG. 3 is a stress-strain graph comparing the compressive strength of a related art micro-truss structure to two sparse micro-truss structures according to embodiments of the present disclosure;

FIG. 4 illustrates the compression strength of a sparse micro-truss structure according to one embodiment of the present disclosure as a function of unit cell sparsity;

FIGS. 5A-5C illustrate tasks of forming a sparse micro-truss structure according to one embodiment of the present disclosure;

FIG. 6 illustrates a mask used during a method of forming a sparse micro-truss structure according to one embodiment of the present disclosure; and

FIG. 7 illustrates a mask used during a method of forming a sparse micro-truss structure according to another embodiment of the present disclosure.

DETAILED DESCRIPTION

Embodiments of the present disclosure are directed to micro-truss structures having a relatively sparse arrangement of structural elements compared to related art truss structures. In the context of the embodiments of the present disclosure, a micro-truss structure is an ordered three-dimensional structure at the micrometer scale. Embodiments of the micro-truss structures of the present disclosure are configured to exhibit improved mechanical performance compared to related art micro-truss structures having the same relative density. The micro-truss structures of the present disclosure may be incorporated into any suitable structure, such as, for instance, in an automobile (e.g., as a chassis component, an impact beam, floorboards, stiffeners, or enclosures) or an aircraft (e.g., hull components, wings, control surfaces, rotor blades, or floorboards). Additionally, embodiments of the micro-truss structures of the present disclosure may be used as a fluid conduit due to the open-cell arrangement of micro-truss structures.

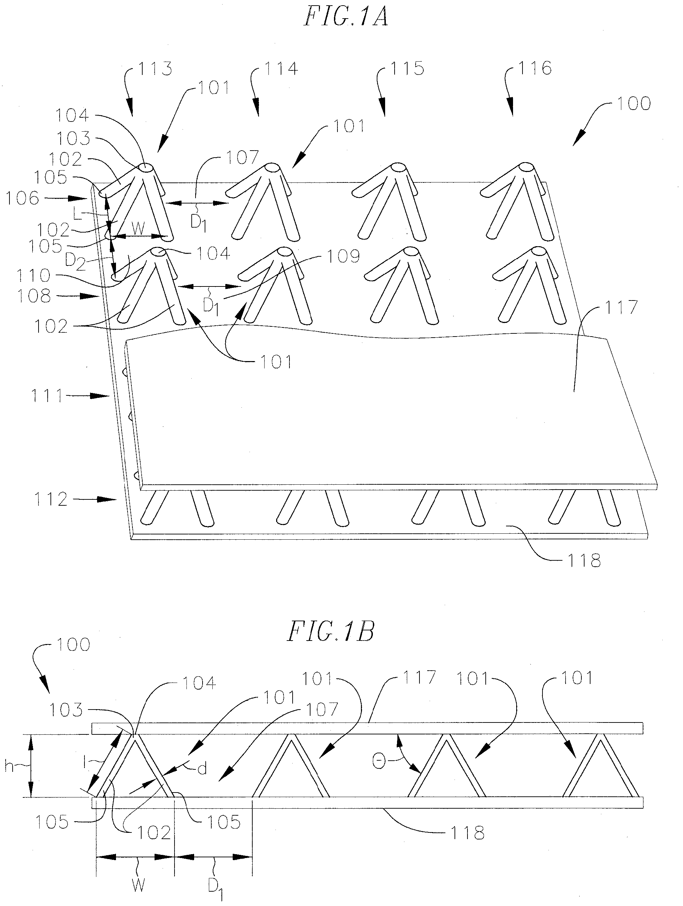

With reference now to FIGS. 1A and 1B, a sparse micro-truss structure 100 according to one embodiment of the present disclosure includes a plurality of unit cells 101 arranged in an ordered array having a plurality of rows and a plurality of columns. In the illustrated embodiment, the array is rectilinear, although in one or more alternate embodiments, the array may have any other suitable configuration, such as, for instance, a circular array. Accordingly, the rows and columns of the array may be either linear or non-linear. Additionally, in the illustrated embodiment, each of the unit cells 101 includes a plurality of interconnected struts 102 (e.g., a unit cell 101 is defined by a grouping of interconnected struts 102). In each unit cell 101, upper ends 103 of the struts 102 intersect and are interconnected at a node 104. In the illustrated embodiment, each of the struts 102 has a length l measured from a lower end 105 of the strut 102 to the upper end 103 of the strut 102 at the node 104. Although in the illustrated embodiment the length l of the struts 102 is constant across the sparse micro-truss structure 100, in one or more alternate embodiments, the length l of the struts 102 may vary across the sparse micro-truss structure 100 (e.g., the length l of the struts 102 may vary between the unit cells 101). Additionally, in the illustrated embodiment, each unit cell has a height h. Although in the illustrated embodiment the height h of the unit cells 101 is constant across the sparse micro-truss structure 100, in one or more alternate embodiments, the height h of the unit cells 101 may vary across the sparse micro-truss structure 100 (e.g., the height h of the unit cells 101 may vary between the unit cells 101). In the illustrated embodiment, the struts 102 have a circular cross-section having an outer diameter d. In one or more alternate embodiments, the struts 102 may have any other cross-sectional shape suitable for the intended application of the sparse micro-truss structure 100, such as, for instance, triangular, pentagonal, hexagonal, polygonal, oval, or star-shaped. Although in the illustrated embodiment each strut 102 has the same diameter d, in one or more embodiments, the diameter d of the struts 102 may vary across the sparse micro-truss structure **100** (e.g., the diameter **d** of the struts **102** may vary between the unit cells **101**). Additionally, in one or more embodiments, the diameter **d** of the struts **102** may vary (e.g., taper) along the length of the strut **102**. The height **h** of the unit cells **101** and the length **l** and diameter **d** of the struts **102** may be selected based on the desired performance characteristics of the sparse micro-truss structure **100**.

With continued reference to the embodiment illustrated in FIGS. 1A and 1B, each of the unit cells **101** in a first row **106** of the sparse micro-truss structure **100** is spaced apart from an adjacent one of the unit cells **101** in the first row **106** by a gap **107** having a distance $D_1$. The distance $D_1$ is measured between the lower ends **105** of the struts **102** of the adjacent unit cells **101** in the first row **106**. Accordingly, the struts **102** of each of the unit cells **101** are disconnected from the struts **102** of the adjacent unit cells **101** in the first row **106**. In the illustrated embodiment, the distance $D_1$ that adjacent unit cells **101** are spaced apart is equal or substantially equal to a width **W of** the unit cells **101** defined between the lower ends **105** of the struts **102,** although in one or more alternate embodiments, the unit cells **101** in the in the first row **106** may be spaced apart by any other suitable distance depending on the desired performance characteristics of the sparse micro-truss structure **100** (e.g., the adjacent unit cells **101** in the first row **106** may be spaced apart by a distance greater or less than the width **W** of the unit cells **101** in the first row **106**). Additionally, although in the illustrated embodiment the unit cells **101** in the first row are equidistantly spaced apart (i.e., uniformly spaced apart), in one or more embodiments, the unit cells **101** in the cells first row **106** may be non-uniformly or irregularly spaced apart.

In the illustrated embodiment, each unit cell **101** in the first row **106** includes four struts **102** oriented or arranged in a square base pyramid shape. In one or more alternate embodiments, the unit cells **101** in the first row **106** may include any other suitable number of struts **102** and the struts **102** may be arranged into any other suitable configuration, such as, for instance, three struts arranged in a tetrahedron shape (i.e., a triangular base pyramid shape) or five struts arranged in a pentagonal base pyramid shape. Although in the illustrated embodiment each of the unit cells **101** in the first row **106** have the same number of struts **102** that are arranged in the same configuration, in one or more embodiments, the number of struts **102** in each unit cell **101** may vary across the first row **106**. Additionally, as illustrated in FIG. 1B, the struts **102** in each unit cell **101** in the first row **106** may be oriented at any suitable inclination angle θ relative an imaginary horizontal plane, such as, for instance, from approximately (about) 20 degrees to approximately (about) 70 degrees. In the illustrated embodiment, the struts **102** of each unit cell **101** in the first row **106** are oriented at an inclination angle θ of approximately (about) 60 degrees.

Still referring to the embodiment illustrated in FIGS. 1A and 1B, a second row **108** of the sparse micro-truss structure **100** includes a plurality of unit cells **101** that are aligned with the unit cells **101** in the first row **106**. Accordingly, adjacent unit cells **101** in the second row **108** are spaced apart by a gap **109** having the same distance $D_1$ as adjacent unit cells **101** in the first row **106**. Furthermore, in the illustrated embodiment, the unit cells **101** in the second row **108** are spaced apart from corresponding unit cells **101** in the first row **106** by a gap **110** having a distance $D_2$. In the illustrated embodiment, the distance $D_2$ between the unit cells **101** in the second row **108** and the corresponding unit cells **101** in the first row **106** is equal or substantially equal to a length **L** of the corresponding unit cells **101** in the first row **106** defined between lower ends **105** of the struts **102**. In one or more alternate embodiments, the unit cells **101** in the in the second row **108** maybe spaced apart from the corresponding unit cells **101** in the first row **106** by any other suitable distance depending on the desired performance characteristics of the sparse micro-truss structure **100** (e.g., the unit cells **101** in the second row **108** may be spaced apart from the corresponding unit cells **101** in the first row **106** by a distance $D_2$ greater or less than the length **L** of the corresponding unit cells **101** in the first row **106**). Additionally, in the illustrated embodiment, the distance $D_2$ that the unit cells **101** in the second row **108** are spaced apart from the corresponding unit cells **101** in the first row **106** is equal or substantially equal to the distance $D_1$ that adjacent unit cells **101** in the first row **106** are spaced apart. In one or more alternate embodiments, the distance $D_1$ may be different than the distance $D_2$. Separating the unit cells **101** within each row **106, 108** and separating the unit cells **101** between adjacent rows **106, 108** is configured to reduce the sensitivity of the sparse micro-truss structure **100** to premature failure (e.g., premature buckling or bending deformation) due to manufacturing defects in one or more of the struts **102** compared to related art micro-truss structures having a plurality of fully interconnected unit cells (i.e., related art micro-truss structures in which the struts in each unit cell are coupled to adjacent unit cells in the same row and are coupled to adjacent unit cells in adjacent rows).

Additionally, in the illustrated embodiment, each of the unit cells **101** in the second row includes **108** four struts **102** oriented or arranged into an square-based pyramid shape, although in one or more alternate embodiments, the unit cells **101** in the second row **108** may include any other suitable number of struts **102** and the struts **102** may be arranged into any other suitable configuration, such as, for instance, three struts arranged in a tetrahedron shape (i.e., a triangular based pyramid shape) or five struts arranged in a pentagonal pyramid shape. Additionally, in the illustrated embodiment, the unit cells **101** in the second row **108** have the same configuration as the unit cells **101** in the first row **106,** although in one or more alternate embodiments, the unit cells **101** in the second row **108** may have a different configuration than the unit cells **101** in the first row **106**. Although in the illustrated embodiment each of the unit cells **101** in the second row **108** have the same number of struts **102** that are arranged in the same configuration, in one or more embodiments, the number of struts **102** in each unit cell **101** may vary across the second row **108**.

In the illustrated embodiment, the sparse micro-truss structure **100** also includes a third row **111** and a fourth row **112** of unit cells **101**. The third and fourth rows **111, 112** of unit cells **101** may have the same or substantially the same configuration as the first row **106** and/or the second row **108**. Accordingly, in the illustrated embodiment the sparse micro-truss structure **100** includes four rows **106, 108, 111, 112** and four columns **113, 114, 115, 116** of unit cells **101**. Although in the illustrated embodiment the sparse micro-truss structure **100** includes four rows **106, 108, 111, 112** and each row includes four unit cells **101,** in one or more embodiments, the sparse micro-truss structure **100** may include any other suitable number of rows and each row **106, 108, 111, 112** may include any other suitable number of unit cells **101** depending, for instance, on the desired size and performance characteristics of the sparse micro-truss structure **100.** Additionally, in one or more embodiments, the number of rows **106, 108, 111, 112** may be different than the number of columns **113, 114, 115, 116.** Additionally, in the illustrated embodiment, the unit cells **101** are half unit cells. In one or more alternate embodiments, the unit cells **101** may be full unit cells. Full unit cells are half unit cells mirrored about an imaginary plane extending through the nodes **104**. In an embodiment in which the unit cells **101** are full unit cells, the struts **102** may intersect and define a node at an intermediate portion along the struts **102** (e.g., each unit cell **101** may include a node located at or proximate a center of the struts **102**). In one or more embodiments, the unit cells **101** may be half unit cells mirrored about an imaginary plane extending through lower ends **105** of the struts **102**. For instance, in one or more embodiments, the unit cells **101** may be octahedral shaped unit cells. In another embodiment, the sparse micro-truss structure **100** may include a plurality of layers, each layer having an array of half unit cells or full unit cells, stacked on top of each other. In one embodiment, adjacent layers may be separated by a facesheet or other structural member.

Additionally, the struts **102** may be either solid or hollow. In an embodiment in which the struts **102** are hollow, the struts **102** may have any suitable wall thickness depending on the desired performance characteristics of the sparse micro-truss structure **100**. The struts **102** may be made out any material suitable for the intended application of the sparse micro-truss structure **100** and the desired mechanical properties of the sparse micro-truss structure **100,** such as, for instance, polymer (e.g., parylene), metal (e.g., nickel, aluminum), metal alloy (e.g., nickel-phosphorous alloy), ceramic, or any combination thereof.

With continued reference to the embodiment illustrated in FIGS. 1A and 1B, the sparse-truss structure **100** also includes an upper facesheet **117** coupled to the nodes **104** and a lower facesheet **118** coupled to the lower ends **105** of the struts **102**. In FIG. 1A, the upper facesheet **118** is broken away to reveal the unit cells **101** in the first and second rows **106, 108.** The upper and lower facesheets **117, 118** may be made out of any suitable material depending on the desired performance characteristics of the sparse micro-truss structure **100.** The facesheets **117, 118** may be made out of the same material as the struts **102** or a material dissimilar from the material of the struts **102**. The facesheets **117, 118** may be either integrally formed with the unit cells **101** or separately formed and coupled to the unit cells **101** by any suitable manufacturing process or technique, such as, for instance, bonding or adhering. Additionally, although in the illustrated embodiment the upper and lower facesheets **117, 118** are planar or substantially planar, in one or more alternate embodiments, the upper facesheet **117** and/or the lower facesheet **118** may be non-planar (e.g., the upper facesheet **117** and/or the lower facesheet **118** may be curved). In one or more embodiments, the sparse micro-truss structure **100** may be provided without the upper facesheet **117** and/or without the lower facesheet **118**.

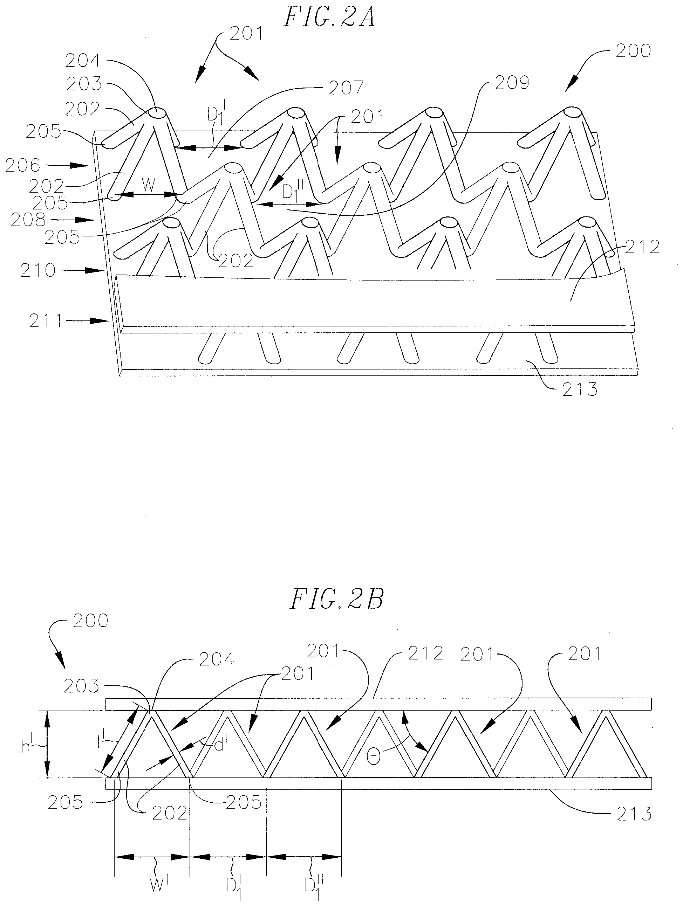

With reference now to FIGS. 2A and 2B, a sparse micro-truss structure **200** according to another embodiment of the present disclosure includes a plurality of unit cells **201** arranged in a staggered or offset array having a plurality of rows. In the illustrated embodiment, the array is rectilinear, although in one or more alternate embodiments, the array may have any other suitable configuration, such as, for instance, a circular array. Additionally, in the illustrated embodiment, each of the unit cells **201** includes a plurality of interconnected struts **202**. In each unit cell **201**, upper ends **203** of the struts **202** intersect and are interconnected at a node **204**. In the illustrated embodiment, each of the struts **202** has a length **l'** measured from a lower end **205** of the strut **202** to the upper end **203** of the strut **202** at the node **204**. Although in the illustrated embodiment the length **l'** of the struts **202** is constant across the sparse micro-truss structure **200,** in one or more alternate embodiments, the length **l'** of the struts **202** may vary across the sparse micro-truss structure **200** (e.g., the length **l'** of the struts **202** may vary between the unit cells **201**). Additionally, in the illustrated embodiment, each unit cell has a height **h'.** Although in the illustrated embodiment the height **h'** of the unit cells **201** is constant across the sparse micro-truss structure **200,** in one or more alternate embodiments, the height **h'** of the unit cells **201** may vary across the sparse micro-truss structure **200** (e.g., the height **h'** of the unit cells **201** may vary between the unit cells **201**). In the illustrated embodiment, the struts **202** have a circular cross-section having an outer diameter **d'.** In one or more alternate embodiments, the struts **202** may have any other cross-sectional shape suitable for the intended application of the sparse micro-truss structure **200,** such as, for instance, triangular, pentagonal, hexagonal, polygonal, oval, or star-shaped. Although in the illustrated embodiment each strut **202** has the same diameter **d',** in one or more embodiments, the diameter **d'** of the struts **202** may vary across the sparse micro-truss structure **200** (e.g., the diameter **d'** of the struts **202** may vary between the unit cells **201).** Additionally, in one or more embodiments, the diameter **d'** of the struts **202** may vary (e.g., taper) along the length of the strut **202.** The height **h'** of the unit cells **201** and the length **l'** and diameter **d'** of the struts **202** may be selected based on the desired performance characteristics of the sparse micro-truss structure **200.**

With continued reference to the embodiment illustrated in FIGS. 2A and 2B, each of the unit cells **201** in a first row **206** of the sparse micro-truss structure **200** is spaced apart from an adjacent one of the unit cells **201** in the first row **206** by a gap **207** having a distance $D_{1'}$. The distance $D_{1'}$ is measured between the lower ends **205** of the struts **202** of the adjacent unit cells **201** in the first row **206**. Accordingly, the struts **202** of each of the unit cells **201** are disconnected from the struts **202** of the adjacent unit cells **201** in the first row **206**. In the illustrated embodiment, the distance $D_{1'}$ that adjacent unit cells **201** in the first row **206** are spaced apart is equal or substantially equal to a width **W'** of the unit cells **201** in the first row **206** defined between the lower ends **205** of the struts **202**, although in one or more alternate embodiments, the unit cells **201** in the in the first row **206** maybe spaced apart by any other suitable distance depending on the desired performance characteristics of the sparse micro-truss structure **200** (e.g., the adjacent unit cells **201** in the first row **206** may be spaced apart by a distance greater or less than the width **W'** of the unit cells **201** in the first row **206**). Additionally, although in the illustrated embodiment the unit cells **201** in the first row **206** are equidistantly space apart (i.e., uniformly spaced apart), in one or more embodiments, the unit cells **201** of the first row **206** may be non-uniformly or irregularly spaced apart.

In the illustrated embodiment, each unit cell **201** in the first row **206** includes four struts **202** oriented or arranged into an square pyramid shape, in one or more alternate embodiments, the unit cells **201** may include any other suitable number of struts **202** and the struts **202** may be arranged into any other suitable configuration, such as, for instance, three struts arranged in a tetrahedron shape (i.e., a triangular based pyramid shape) or five struts arranged in a pentagonal base pyramid shape. Additionally, as illustrated in FIG. 2B, the struts **202** of each unit cell **201** may be oriented at any suitable inclination angle $\theta'$ relative to an imaginary horizontal plane, such as, for instance, from approximately (about) 20 degrees to approximately (about) 70 degrees. In the illustrated embodiment, the struts **202** of each unit cell **201** in the first row **206** are oriented at an inclination angle $\theta'$ of approximately (about) 60 degrees.

Still referring to the embodiment illustrated in FIGS. 2A and 2B, a second row **208** of the sparse micro-truss structure **200** includes a plurality of unit cells **201** that are laterally offset from the unit cells **201** in the first row **206**. In the illustrated embodiment, the unit cells **201** in the second row **208** are aligned with the gaps **207** between the adjacent unit cells **201** in the first row **206**, although in one or more alternate embodiments, the unit cells **201** in the second row **208** may be only partially aligned with the gaps **207** defined between the unit cells **201** in the first row **206** (i.e., the unit cells **201** in the second row **208** may be only partially offset from the unit cells **201** in the first row **206**). Additionally, the unit cells **201** are spaced apart from adjacent unit cells **201** in the second row **208** by a gap **209** having a distance $D_{1''}$. In the illustrated embodiment, the adjacent unit cells **201** in the second row **208** are spaced apart by the same distance $D_{1'}$ as adjacent unit cells **201** in the first row **206**, although in one or more embodiments, the adjacent unit cells **201** in the second row **208** may be spaced apart by a distance $D_{1''}$ that is different than the distance $D_{1'}$ the adjacent unit cells **201** in the first row **206** are spaced apart. Additionally, although in the illustrated embodiment the unit cells **201** in the second row **208** are equidistantly space apart (i.e., uniformly spaced apart), in one or more embodiments, the unit cells **201** of the second row **208** may be non-uniformly or irregularly spaced apart.

Additionally, in the illustrated embodiment, each of the unit cells **201** in the second row **208** includes four struts **202** oriented or arranged into an square pyramid shape, although in one or more alternate embodiments, the unit cells **201** may include any other suitable number of struts **202** and the struts **202** may be arranged into any other suitable configuration, such as, for instance, three struts arranged in a tetrahedron shape (i.e., a triangular based pyramid shape) or five struts arranged in a pentagonal pyramid shape. Additionally, in the illustrated embodiment, the unit cells **201** in the second row **208** have the same configuration as the unit cells **201** in the first row **206**, although in one or more alternate embodiments, the unit cells **201** in the second row **208** may have a different configuration than the unit cells **201** in the first row **206**.

In the illustrated embodiment, the sparse micro-truss structure **200** also includes a third row **210** of unit cells **201** that has the same or similar configuration as the first row **206** and a fourth row **211** of unit cells **201** that has the same or similar configuration as the second row **208**. Although in the illustrated embodiment, the sparse micro-truss structure **200** includes four rows **206, 208, 210, 211,** in one or more embodiments, the sparse micro-truss structure **200** may include any other suitable number of rows **206, 208, 210, 211** and each row **206, 208, 210, 211** may include any suitable number of unit cells **201** depending, for instance, on the desired size and performance characteristics of the sparse micro-truss structure **200.**

In the embodiment illustrated in FIG. 2A, the lower end **205** of each of the struts **202** in the second row **208** is coupled to the lower end **205** of one of the struts **202** in either the first row **206** or the third row **210**. Accordingly, in the illustrated embodiment, the unit cells **201** in the first row **206** are spaced apart from adjacent unit cells **201** in the first row **206** and the unit cells **201** in the second row **208** are spaced apart from adjacent unit cells **201** in the second row **208,** but the unit cells **201** in the first row **206** are coupled to the unit cells **201** in the second row **208**. Accordingly, the embodiment of the sparse micro-truss structure **200** illustrated in FIG. 2A and 2B has reduced interconnectivity compared to a related art micro-truss structure in which the unit cells are coupled both to adjacent unit cells in the same row and to adjacent unit cells in adjacent rows. Separating the unit cells **201** within each row **206, 208, 210, 211** is configured to reduce the sensitivity of the sparse micro-truss structure **200** to premature failure (e.g., premature buckling or bending deformation) due to manufacturing defects in one or more of the struts **202** compared to related art micro-truss structures having a plurality of fully interconnected unit cells. In one or more alternate embodiments, the unit cells **201** in the second row **208** may be spaced apart from the unit cells **201** in the first row **206** by any suitable distance depending, for instance, on the desired performance characteristics of the sparse micro-truss structure **200.**

Additionally, in the illustrated embodiment, the unit cells **201** are half unit cells. In one or more alternate embodiments, the unit cells **201** may be full unit cells. In an embodiment in which the unit cells **201** are full unit cells, the struts **202** may intersect and define a node at an intermediate portion along the struts **202** (e.g., each unit cell **201** may include a node located at or proximate a center of the struts **202**). In one or more embodiments, the unit cells **201** may be half unit cells mirrored about an imaginary plane extending through lower ends **205** of the struts **202**. For instance, in one or more embodiments, the unit cells may be octahedral shaped unit cells. In another embodiment, the sparse micro-truss structure **200** may include a plurality of layers, each layer having an array of half unit cells or full unit cells, stacked on top of each other. In one embodiment, adjacent layers may be separated by a facesheet or other structural member.

Additionally, the struts **202** may be either solid or hollow. In an embodiment in which the struts **202** are hollow, the struts **202** may have any suitable wall thickness depending on the desired performance characteristics of the sparse micro-truss structure **200**. The struts **202** may be made out any material suitable for the intended application of the sparse micro-truss structure **200** and the desired mechanical properties of the sparse micro-truss structure **200,** such as, for instance, polymer (e.g., parylene), metal (e.g., nickel, aluminum), metal alloy (e.g., nickel-phosphorous alloy), ceramic, or any combination thereof.

With continued reference to the embodiment illustrated in FIGS. 2A and 2B, the sparse-truss structure **200** also includes an upper facesheet **212** coupled to the nodes **204** and a lower facesheet **213** coupled to the lower ends **205** of the struts **202.** In FIG. 2A, the upper facesheet **212** is broken away to reveal the unit cells **201** in the first and second rows **206, 208.** The upper and lower facesheets **212, 213** may be made out of any suitable material depending on the desired performance characteristics of the sparse micro-truss structure **200.** The facesheets **212, 213** may be made out of the same material as the struts **202** or a material dissimilar from the material of the struts **202.** The facesheets **212, 213** may be either integrally formed with the unit cells **201** or separately formed and coupled to the unit cells **201** by any suitable manufacturing process or technique, such as, for instance, bonding or adhering. Additionally, although in the illustrated embodiment the upper and lower facesheets **212, 213** are planar or substantially planar, in one or more alternate embodiments, the upper facesheet **212** and/or the lower facesheet **213** may be non-planar (e.g., the upper facesheet **212** and/or the lower facesheet **213** may be curved). In one or more embodiments, the sparse micro-truss structure **200** may be provided without the upper facesheet **212** and/or without the lower facesheet **213.**

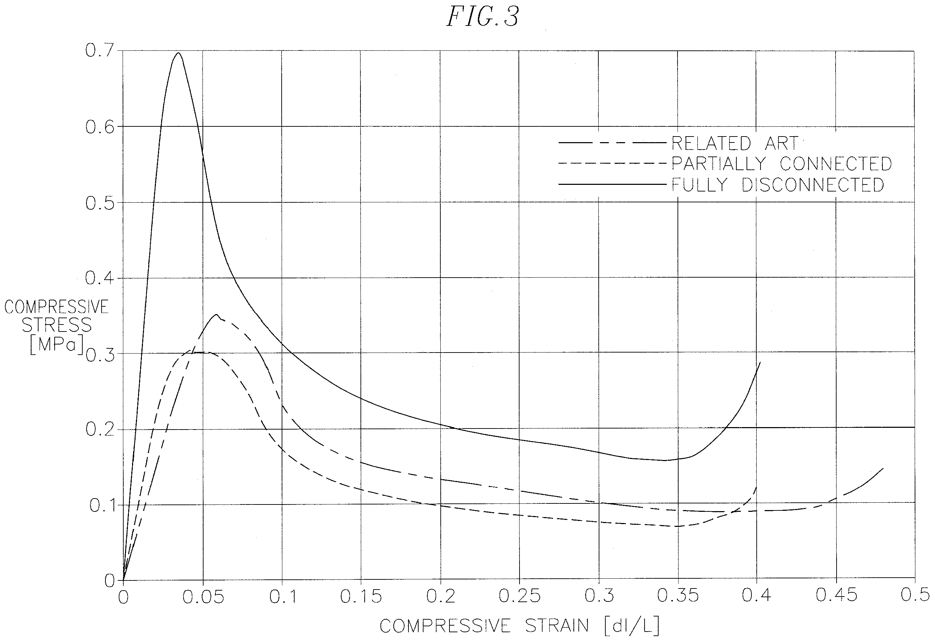

The embodiments of the sparse micro-truss structures **100, 200** of the present disclosure were compression tested with a screw-driven universal testing machine. FIG. 3 is graph illustrating the stress and strain exhibited by the sparse micro-truss structures **100, 200** of the present disclosure and a related art micro-truss structure when subject to compressive loading. As illustrated in FIG. 3, the embodiment of the sparse micro-truss structure **100** illustrated in FIGS. 1A and 1B exhibited a maximum compressive stress of approximately (about) 0.7 MPa at a compressive strain ($\Delta l/L$) of approximately (about) 0.03. The embodiment of the sparse micro-truss structure **200** illustrated in FIGS. 2A and 2B exhibited a maximum compressive stress of approximately (about) 0.3 MPa at a compressive strain of approximately (about) 0.05.

Further, as illustrated in FIG. 3, a related art micro-truss structure including a series of fully interconnected unit cells exhibited a maximum compressive stress of approximately (about) 0.35 MPa at a compressive strain of approximately (about) 0.06. Accordingly, the embodiment of the sparse micro-truss structure **100** illustrated in FIGS. 1A and 1B exhibited a maximum compressive stress of approximately (or about) twice the maximum compressive stress exhibited by the related art micro-truss structure. Thus, the embodiment of the sparse micro-truss structure **100** illustrated in FIGS. 1A and 1B exhibited increased mechanical performance compared to the related art micro-truss structure over the entire range of the compressive loads applied to the micro-truss structures.

The table below summarizes the test results of the embodiments of the sparse micro-truss structure **100, 200** of the present disclosure and a related art micro-truss structure.

| | Baseline Conventional Structure | Partially Connected Unit Cells (e.g., FIGS. 2A, 2B) | Fully Disconnected Unit Cells (e.g., FIGS. 1A, 1B) |
|---|---|---|---|
| **Compressive Strength (MPa)** | 0.33 | 0.30 | 0.70 |

(continued)

|  | Baseline Conventional Structure | Partially Connected Unit Cells (e.g., FIGS. 2A, 2B) | Fully Disconnected Unit Cells (e.g., FIGS. 1A, 1B) |
|---|---|---|---|
| Compressive Modulus (MPa) | 7.45 | 10.85 | 26.33 |
| Specific Strength (MPa/(g/cc)) | 4.94 | 7.25 | 15.85 |
| Specific Compressive Modulus (MPa/(g/cc)) | 111.82 | 258.35 | 599.26 |
| Relative Density | 4.97% | 3.13% | 3.28% |

As described in more detail below, the degree of reduced interconnectivity between the unit cells compared to a related art fully interconnected micro-truss structure (i.e., the sparsity of the sparse micro-truss structure) may be selected based on the desired performance characteristics (e.g., compressive strength and shear strength) of the sparse micro-truss structure. Additionally, the size of the struts (e.g., the slenderness or aspect ratio of the struts) may be selected based on the desired performance characteristics of the sparse micro-truss structure. The size of the struts of the sparse micro-truss structure may also be selected to maintain the same mass as the related art fully interconnected micro-truss structure despite the relatively higher sparsity of the unit cells in the sparse micro-truss structure.

Depending on the size of the struts in the sparse micro-truss structure, the critical buckling stress for individual solid struts is defined by either Johnson dominated buckling or Euler dominated buckling, as follows:

$$\sigma_{Euler} = \frac{c\pi^2 E}{\left(\frac{l}{r^*}\right)^2}$$

$$\sigma_{Johnson} = \sigma_y \left( 1 - \frac{\sigma_y \left(\frac{l}{r^*}\right)^2}{4c\pi^2 E} \right),$$

where $E$ is Young's modulus of the strut material (e.g., polymer (e.g., parylene), metal (e.g., nickel, aluminum), metal alloy (e.g., nickel-phosphorous alloy), ceramic, or any combination thereof), $\sigma_y$ is the yield strength of the strut material, $l$ is the length of the strut, $c$ is a parameter that can vary between 0.25 and 4 and that describes the end conditions of the struts, and $r^*$ is the radius of gyration, which is defined as:

$$r^* = \sqrt{\frac{I}{A}} ,$$

where $I$ is the area moment of inertia of the strut cross-section and $A$ is the area of the strut cross-section. If the ratio of strut length $l$ to radius of gyration $r^*$ is greater than or equal to $\pi\sqrt{2cE/\sigma_y}$ then the critical stress, $\sigma_{crit}$, is Euler-buckling stress ($\sigma_{Euler}$) and if the ratio of strut length $l$ to radius of gyration $r^*$ is less than $\pi\sqrt{2cE/\sigma_y}$ then the critical stress, $\sigma_{crit}$, is Johnson- buckling stress ($\sigma_{Johnson}$), as shown below:

$$\sigma_{crit} = \begin{cases} \sigma_{Euler}; & l/r^* \geq \pi\sqrt{2cE/\sigma_y} \\ \sigma_{Johnson}; & l/r^* < \pi\sqrt{2cE/\sigma_y} \end{cases}$$

In one embodiment, the diameter of the struts may be selected such that the sparse micro-truss structure exhibits Johnson buckling (i.e., the ratio $l/r^*$ of the struts may be selected to be greater than or equal to $\pi\sqrt{2cE/\sigma_y}$ such that the sparse micro-truss structure does not exhibit Euler buckling). In one embodiment, the sparsity of the sparse micro-truss structure and the diameter of the struts may be selected such that the yield strength $\sigma_y$ exceeds the critical stress, $\sigma_{crit}$. In an embodiment in which the struts are hollow tubes, the wall thickness of the hollow tubes may be selected to prevent local buckling modes (e.g., shear wrinkling) of the hollow tubular struts.

The compressive strength, $\sigma_{compression}$, of a micro-truss structure having a plurality of pyramidal unit cells (e.g., the sparse micro-truss structures **100** or **200** described above with reference to FIGS. 1A, 1B and FIGS. 2A, 2B, respectively) is related to the critical stress, $\sigma_{crit}$, of individual struts as follows:

$$\sigma_{compression} = \rho^* \sin^2(\theta)\, \sigma_{crit},$$

where $\rho^*$ is the relative density (i.e., volume fraction) of the micro-truss structure and $\theta$ is the inclination angle of the struts in each unit cell (i.e., the angle defined between the struts in each unit cell and an imaginary horizontal plane).

The shear strength, $\tau$, of a micro-truss structure having a plurality of pyramidal unit cells (e.g., the sparse micro-truss structures **100** and **200** described above with reference to FIGS. 1A, 1B and FIGS. 2A, 2B, respectively) is related to the critical stress, $\sigma_{crit}$, of individual struts as follows:

$$\tau = \frac{\rho^*}{4} \frac{\sin^2(\theta)}{\cos(\psi)}\, \sigma_{crit},$$

where $\psi \leq 45°$ is the angle between the shear loading direction and the longitudinal direction of one of the struts in the unit cell.

The relative density, $\rho^*$, of a micro-truss structure having a plurality of pyramidal unit cells is determined as follows:

$$\rho^* = \frac{2\pi r_o^2}{L_0^2 \cos^2 \theta \sin \theta}$$

where $r_o$ and $L_o$ are the radius and the length, respectively, of the individual struts of the unit cells.

Accordingly, there are three geometric parameters that can be changed or selected to increase the mechanical performance (e.g., the shear strength $\tau$ and the compressive strength $\sigma_{compression}$) of the sparse micro-truss structure: (1) the strut inclination angle $\theta$; (2) the relative density $\rho^*$ of the sparse micro-truss structure; and (3) slenderness ratio of the struts (e.g., the ratio of the length of the struts to the diameter of the struts). However, increasing the strut inclination angle $\theta$ to an angle greater than 60 degrees improves compressive strength $\sigma_{compression}$ at the expense of reduced shear strength $\tau$. Additionally, increasing the relative density $\rho^*$ of the micro-truss structure comes at the expense of increasing the overall mass of the structure. In low relative density structures, the primary failure mode is generally strut buckling, and therefore reducing the slenderness ratio $\rho^*$ of the struts may improve both the shear strength and the compressive strength of the micro-truss structure.

In one embodiment, the sparse micro-truss structures **100, 200** of the present disclosure may have improved mechanical performance (e.g., improved shear strength $\tau$ and compressive strength $\sigma_{compression}$) without an increase in mass compared to an otherwise comparable related art micro-truss structure having a plurality of fully interconnected unit cells (i.e., the sparse micro-truss structures may have the same or substantially the same mass as an otherwise comparable related art micro-truss structure having a plurality of fully interconnected unit cells but with improved mechanical performance). As described above, the mechanical performance of the sparse micro-truss structure may be increased by reducing the slenderness ratio of the struts (e.g., increasing the radius of the struts). The constant mass may be maintained by increasing the radius of the struts with the mass saved by reducing the number of unit cells (i.e., reducing the slenderness ratio of the struts by redistributing the mass saved from increasing the sparsity of the micro-truss structure). Accordingly, the sparse micro-truss structures of the present disclosure may have improved mechanical performance compared to related art fully populated micro-truss structures due to the reduced slenderness ratio of the struts while maintaining the same overall mass as a related art fully populated micro-truss structure by increasing the sparsity of the micro-truss structure. For hollow tubular struts, the constant mass may be maintained by increasing the wall thickness of the hollow tubular struts. The increase in radius $r_o$ and length $L_o$, respectively, of the struts necessary to maintain the same mass as the related art micro-truss structure is expressed as follows:

$$r = \sqrt{n}r_o$$

$$L = \sqrt{n}L_o \, ,$$

where $n$ is the sparsity of the sparse micro-truss structure, which is defined as the ratio of the number of unit cells in a related art fully interconnected micro-truss structure to the number of unit cells in the sparse micro-truss structure. For instance, the embodiment of the sparse micro-truss structure 100 illustrated in FIGS. 1A and 1B has a sparsity n of 49/16≈3 and the embodiment of the sparse micro-truss structure 200 illustrated in FIGS. 2A and 2B has a sparsity $n$ of 28/14=2 (e.g., a related art fully populated and interconnected micro-truss structure with the same overall dimensions as the sparse micro-truss structure in FIGS. 1A and 1B would have 49 unit cells (i.e., 7 rows and 7 columns) and a related art fully populated and interconnected micro-truss structure with the same overall dimensions as the sparse micro-truss structure in FIGS. 2A and 2B would have 28 unit cells (i.e., 4 rows and 7 columns), but the sparse micro-truss structure **100** in FIGS. 1A and 1B has only 16 unit cells and the sparse micro-truss structure **200** in FIGS. 2A and 2B has only 14 unit cells).

Relative density is then calculated as:

$$\rho^* = \frac{2\pi r^2}{L^2 \cos^2 \theta \sin \theta} = \frac{2\pi \left(\sqrt{n}r_0\right)^2}{\left(\sqrt{n}L_0\right)^2 \cos^2 \theta \sin \theta} = \frac{2\pi r_o^2}{L_0^2 \cos^2 \theta \sin \theta}$$

Thus, the relative density $\rho^*$ is kept constant for any degree of sparsity $n$.

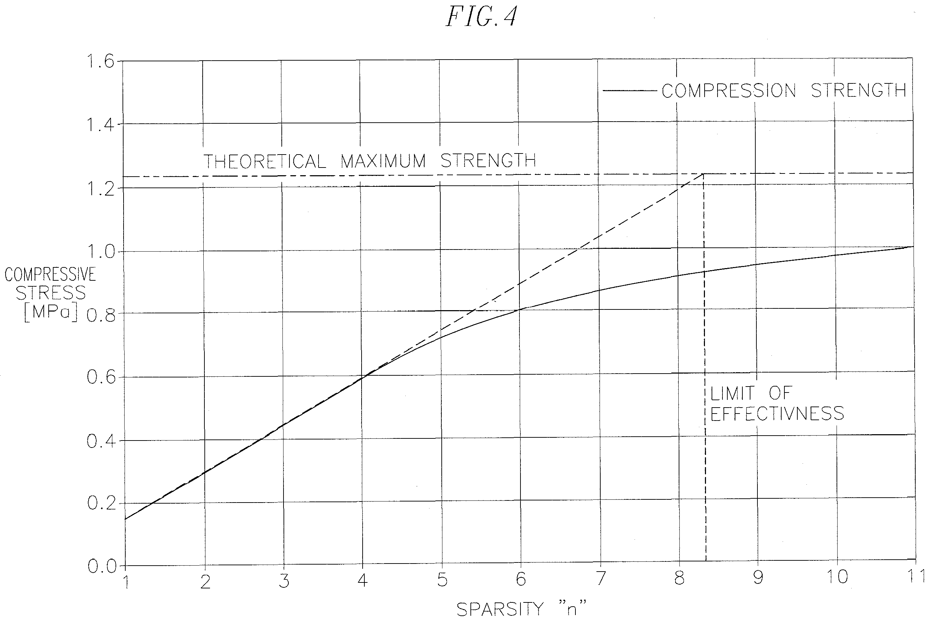

FIG. 4 illustrates the compressive strength of a sparse micro-truss structure according to one embodiment of the present disclosure as a function of sparsity $n$ where the sparse micro-truss structure has struts with a radius $r_o$ of 0.45mm, an inclination angle θ of 60°, a virtual strut length $L$ of 14.665mm, a yield strength $\sigma_y$ of 60 MPA, a Young's Modulus $E$ of 3.1 GPa, a strut end condition c of 1, and a relative density $\overline{\rho^*}$ of 2.73%.

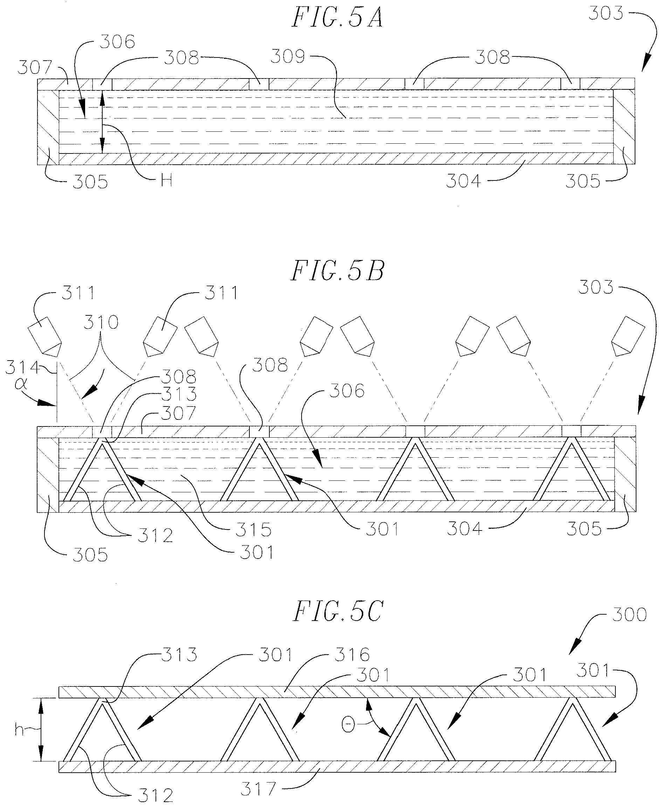

FIGS. 5A-5C illustrate a method of manufacturing a sparse micro-truss structure **300** having a plurality of unit cells **301** arranged in an array according to one embodiment of the present disclosure. As illustrated in FIG. 5A, the method includes a task of obtaining or providing a mold **303** having a base **304** and vertical wall or rim **305** extending upward from a periphery of the base **304**. Together, the base **304** and the rim **305** of the mold **303** define a chamber or reservoir **306**. With continued reference to the embodiment illustrated in FIG. 5A, the method also includes a task of covering an upper end of the mold **303** (e.g., an upper end of the reservoir **306**) with a mask **307**. The mask **307** defines a plurality of apertures **308**. The mask **307** may define any desired number of apertures **308** and the apertures **308** may have any desired size, shape, and spacing, depending upon the desired characteristics of the micro-truss structure, as described below in more detail. The mask **307** may be made of any suitable material, such as, for instance, biaxially-oriented polyethylene terephthalate.

With continued reference to the embodiment illustrated in FIG. 5B, the method includes a task of filling the reservoir **306** with a volume of liquid photo-monomer **309**. The liquid photo-monomer **309** may be filled to any suitable height **H** in the reservoir **306** depending on the desired height **h** of the unit cells **301** of the sparse micro-truss structure **300** (see FIG. 5C). The photo-monomer **309** is configured to polymerize when exposed to light within a particular range of wavelengths, such as, for instance, ultraviolet light (i.e., wavelengths between 250 nm and 400 nm). The liquid photo-monomer **309** may be any suitable type or kind of monomer configured to polymerize when exposed to light, such as, for instance, thiols, acrylates, methacrylates, or cationic polymers (e.g., photo-cured epoxies). Suitable liquid photo-monomers are described in U.S. Patent No. 8,017,193.

Referring now to the embodiment illustrated in FIG. 5B, the method also includes a task of irradiating the volume of liquid photo-monomer **309** in the reservoir **306** with a plurality of light beams **310** (e.g., collimated or substantially collimated ultraviolet light ("UV") beams) from one or more light sources **311**. The task of irradiating the photo-monomer **309** includes directing the collimated light beams **310** from the one or more light sources **311** down through the apertures **308** in the mask **307** and into the volume of liquid photo-monomer **309** in the reservoir **306**. The light sources **311** may be any suitable types or kinds of lamps capable of emitting light beams within a range of wavelengths configured to polymerize the liquid photo-monomer **309,** such as, for instance, mercury arc lamps or light-emitting diodes (LEDs). In one embodiment, the task of irradiating the photo-monomer **309** may also include directing the collimated light beams **310** from the one or more light sources **311** off of one or more mirrors and down through the apertures **308** in the mask **307** and into the liquid photo-monomer **309**. Regions of the liquid photo-monomer **309** that are exposed to the collimated light beams **310** cure (i.e., polymerize). The polymerized regions propagate down through the volume of photo-monomer **309** and form a plurality of polymer optical waveguides **312**. The polymer optical waveguides **312** define the struts of the unit cells **301** of the sparse micro-truss structure **300**. In the illustrated embodiment, the struts **312** of each unit cell **301** intersect and are polymerized at a node **313**. Suitable methods for forming polymer optical waveguides are described in U.S. Patent Nos. 7,653,279 and 7,382,959. The orientation of the polymer optical waveguides **312** of the sparse micro-truss structure **300** depends on the direction in which the polymer optical waveguides **312** propagate through the volume of liquid photo-monomer **309** in the reservoir **306**. In one embodiment, the direction in which the polymer optical waveguides **312** propagate through the volume of photo-monomer **309** is a function of an incident angle $\alpha$ of the one or more light sources **311** and the light beams **310** produced therefrom relative to an imaginary axis **314** perpendicular to the mask **307** (i.e., the orientation of the polymer optical waveguides **312** is a function of the angles $\alpha$ at which the one or more light beams **310** penetrate the volume of photo-monomer **309** in the reservoir **306**).

In one or more alternate embodiments, the direction in which the polymer optical waveguides **312** propagate through the volume of photo-monomer **309** is a function of the orientation of one or more mirrors and the orientation of the one or more light sources **311** relative to the one or more mirrors. Accordingly, the method includes a task of positioning the one or more light sources **311** and/or the one or more mirrors to achieve the desired orientation of the polymer optical waveguides **312**. In one embodiment, the angle $\alpha$ of the light beams **310** corresponds to the desired inclination angle $\theta$ between the struts **312** of the unit cells **301**. The method may also include orienting the light beams **310** depending on the desired configuration of the unit cells **301**. Although in the illustrated embodiment the light beams **310** are oriented to form half unit cells, in one or more alternate embodiments the light beams **310** may be oriented to form full unit cells (i.e., half unit cells mirrored about an imaginary plane extending through the nodes **313**).

The cross-sectional shape and size of the polymer optical waveguides **312** is a function of the shape and size of the collimated light beams **310** directed through the volume of photo-monomer **309**. The cross-sectional shape and size of the collimated light beams **310** directed through the photo-monomer **309** are dependent upon the shape and size of the apertures **308** in the mask **307**. The apertures **308** in the mask **307** may have any desired shape, such as, for instance, circular, triangular, pentagonal, hexagonal, polygonal, oval, or star-shaped. Accordingly, the method may also include a task of selecting a mask having apertures with a shape and size corresponding to the desired cross-sectional shape and size of the polymer optical waveguides **312** (i.e., the struts) of the sparse micro-truss structure **300**.

The configuration of the unit cells **301** also depends on the number of light beams **310** directed through each aperture **308** in the mask **307**. Accordingly, the method includes a task of directing a number of light beams **310** through each aperture **308** in the mask **307** depending on the desired configuration of the unit cells **301**. For instance, in one embodiment, three light beams **310** may be directed through each aperture **308** to form unit cells **301** having a triangular base pyramid shape. In another embodiment, four light beams **310** may be directed through each aperture **308** to form unit cells **301** having a square base pyramid shape.

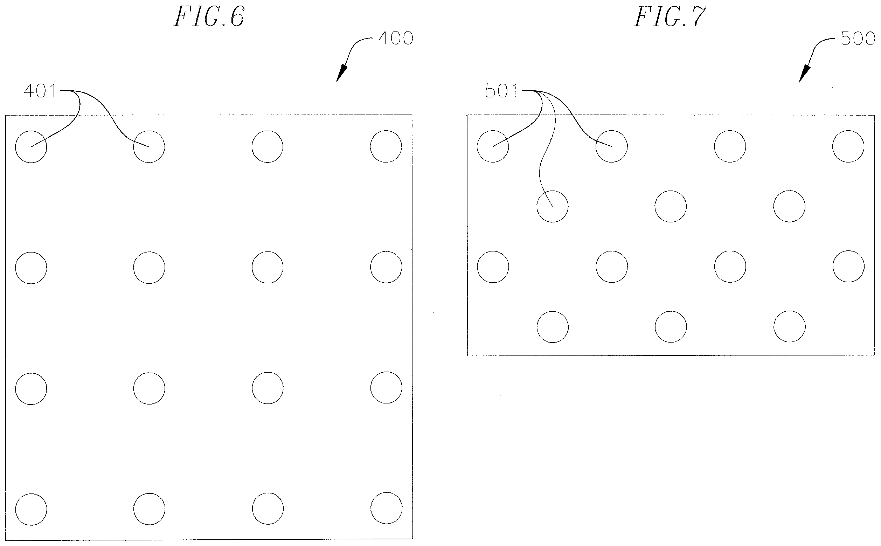

The method also includes a task of selecting a mask **307** having an arrangement of apertures **308** suitable for the desired arrangement and connectivity of the unit cells **301** of the sparse micro-truss structure **300**. For instance, in one embodiment, the method may include a task of selecting the mask **400** illustrated in FIG. 6, which includes a plurality of aligned apertures **401**. In one embodiment, the mask **400** with the aligned apertures **401** in FIG. 6 may be used to produce a sparse micro-truss structure having a series of aligned unit cells that are completely disconnected from adjacent unit cells, as illustrated, for instance, in the embodiment of the sparse micro-truss structure **100** of FIGS. 1A and 1B (i.e., the mask **400** in FIG. 6 may be used to form a sparse micro-truss structure having unit cells that are separated from adjacent unit cells in the same row and that are separated from the unit cells in adjacent rows). In another embodiment, the method may include a task of selecting the mask **500** illustrated in FIG. 7, which includes a plurality of staggered or laterally offset apertures **501**. In one embodiment, the mask **500** with the offset apertures **501** may be used to produce a sparse micro-truss structure having a series of staggered or laterally offset unit cells that are partially connected, as illustrated, for instance, in the embodiment of the sparse micro-truss structure of FIGS. 2A and 2B (i.e., the mask **500** in FIG. 6 may be used to form a sparse micro-truss structure having a series of unit cells that are separated from adjacent unit cells in the same row but that are coupled to unit cells in an adjacent row). The method may also include a task of selecting the mask **307** such that the unit cells **301** are arranged in the desired arrangement. For instance, the method may include a task of selecting the mask **307** such that the unit cells **301** of the sparse micro-truss structure **300** are arranged in a rectilinear array or a circular array. In one embodiment, the method may include selectively blocking out or obstructing some of the apertures in a mask used to form a fully populated and interconnected micro-truss structure.

With reference now to the embodiment illustrated in FIG. 5C, the method also includes a task of removing the sparse micro-truss structure **300** from the reservoir **306** in the mold **303** and a volume of unpolymerized liquid photo-monomer **315** remaining in the reservoir **306**. The method may also include a task of fully curing the polymer optical waveguides **312** (i.e., the struts) of the sparse micro-truss structure **300** after the sparse micro-truss structure **300** has been removed from the reservoir **306**. In one embodiment, the task of fully curing the polymer optical waveguides **312** includes irradiating the polymer optical waveguides **312** with light (e.g., UV light) to fully crosslink the polymer optical waveguides **312**.

With continued reference to the embodiment illustrated in FIG. 5C, the method also includes a task of coupling an upper facesheet **316** and a lower facesheet **317** to the sparse micro-truss structure **300**. The facesheets **316, 317** may be made out of any suitable material, such as, for instance, metal (e.g., aluminum). In one embodiment, the task of coupling the facesheets **316, 317** to the sparse micro-truss structure **300** includes bonding the facesheets **316, 317** to the struts (e.g., the polymer optical waveguides) **312** of the sparse micro-truss structure **300** with a suitable adhesive, such as, for instance, an epoxy adhesive. In one or more alternate embodiments, the struts **312** may be grown directly on one or more of the facesheets **316, 317** such that the facesheets **316, 317** may be coupled to the sparse micro-truss structure **300** without a separate adhesive. For instance, in one embodiment, the upper facesheet **316** may be placed on the upper end of the mold **303** before the task of irradiating the liquid photo-monomer **309** with a plurality of light beams **310**. In an embodiment in which the upper facesheet **316** is placed on the upper end of the mold **303** (e.g., on the upper end of the liquid photo-monomer **309** in the reservoir **306**), the upper facesheet **316** may include a plurality of apertures aligned with the apertures **308** in the mask **307** to allow the light beams **310** to pass through the upper facesheet **316** during the task of irradiating the liquid photo-monomer **309**. In another embodiment, the upper facesheet **317** placed on the upper end of the mold **303** may be made of a translucent material configured to allow the light beams **310** to pass through the upper facesheet **316** during the task of irradiating the liquid photo-monomer **309**. In one embodiment, the method may include submerging the lower facesheet **317** in the volume of liquid photo-monomer **309** in the reservoir **306** before the task of irradiating the liquid photo-monomer **309** with a plurality of light beams **310** (e.g., placing the lower facesheet **317** on the base **304** before filling the reservoir **306** with the liquid photo-monomer **309**).

In one or more embodiments, the method may include a task of forming a sparse micro-truss structure having a plurality of layers stacked on top of each other. Suitable methods for manufacturing a structure having a plurality of stacked micro-truss structures are described in U.S. Patent Application No. 14/461,841 entitled "Stacked Microlattice Materials and Fabrication Processes," filed on August 18, 2014.

Although the struts **312** of the sparse micro-truss structure **300** formed according to the method described above are polymer optical waveguides, in one or more alternate embodiments, the method may include one or more tasks for forming the struts **312** of the sparse micro-truss structure **300** out of any other suitable material, such as, for instance, polymer (e.g., parylene), metal (e.g., nickel, aluminum), metal alloy (e.g., nickel-phosphorous alloy), ceramic, or any combination thereof. In one or more embodiments, the method may include a task of using the polymer optical waveguides as a template onto which one or more dissimilar materials may be deposited onto or formed around. The dissimilar materials may be deposited onto or formed around the polymer optical waveguides by any suitable process, such as, for instance, electrodeposition, electroplating, vapor deposition (e.g., chemical vapor deposition (CVD)), spray coating, dip coating, or any combination thereof. In one embodiment, the method may also include a task of selectively removing the polymer optical waveguides by any suitable process, such as, for instance, by chemically etching the polymer optical waveguides. Selectively removing the polymer optical waveguides leaves a plurality of interconnected hollow tubular struts formed out of the material previously deposited onto the polymer optical waveguides.

Additionally, the method may include one or more tasks for spatially tailoring the mechanical properties of the sparse micro-truss structure **300** (e.g., the method may include one or more tasks for forming a non-uniform sparse micro-truss structure **300**). The strength and stiffness of the sparse micro-truss structure **300** is a function of several factors, including the number of polymer optical waveguides **312** in each unit cell **301,** the orientation of the polymer optical waveguides **312** in each cell **301,** the cross-sectional shape and size of the polymer optical waveguides **312,** the length of the polymer optical waveguides **312,** the spacing between the nodes **313** of the unit cells **301,** and the connectivity of the unit cells **301.** Accordingly, in one or more embodiments, the method may include one or more tasks for varying the number, orientation, shape, size, length, and/or spacing of the polymer optical waveguides **312** across the sparse micro-truss structure **300**. For instance, in one or more embodiments, the method may include a task of selecting a mask having a plurality of apertures that vary in shape and/or size across the mask. Accordingly, when the collimated light beams **310** are directed through the apertures **308** in the mask **307** and into the volume of the photo-monomer **309** to form the polymer optical waveguides **312,** the shape and/or size of the polymer optical waveguides **312** will vary across the sparse micro-truss structure **300** (e.g., the shape and/or size of the polymer optical waveguides **312** may vary between the unit cells **301**). Additionally, in one or more embodiments, the method may include a task of selecting a mask wherein the spacing between the apertures varies across the mask. Accordingly, when the collimated light beams **310** are directed through the apertures **308** in the mask **307** and into the volume of photo-monomer **309** to form the polymer optical waveguides **312,** the spacing between the unit cells **301** will vary across the micro-truss structure **300** (e.g., the spacing between the nodes **313** of the unit cells **301** varies across the sparse micro-truss structure **300**). Additionally, in one or more embodiments, the method may include repositioning the light sources **311** (i.e., varying the incident angles $\alpha$ of the light beams **310**) and/or repositioning the one or more mirrors depending on the position along the mask **307** through which the light beams **310** are directed such that the inclination angle $\theta$ between the struts **312** varies between the unit cells **301** of the sparse micro-truss structure **300.**

While this invention has been described in detail with particular references to exemplary embodiments thereof, the exemplary embodiments described herein are not intended to be exhaustive or to limit the scope of the invention, which is defined by the appended claims. Although relative terms such as "outer," "inner," "upper," "lower," "below," "above," "vertical," "horizontal," and similar terms have been used herein to describe a spatial relationship of one element to another, it is understood that these terms are intended to encompass different orientations of the various elements and components of the invention in addition to the orientation depicted in the figures. Additionally, as used herein, the term "substantially," "about," and similar terms are used as terms of approximation and not as terms of degree, and are intended to account for the inherent deviations in measured or calculated values that would be recognized by those of ordinary skill in the art. Moreover, the tasks described above may be performed in the order described or in any other suitable sequence. Additionally, the methods described above are not limited to the tasks described. Instead, for each embodiment, one or more of the tasks described above may be absent and/or additional tasks may be performed. Furthermore, as used herein, when a component is referred to as being "on" another component, it can be directly on the other component or components may also be present therebetween. Moreover, when a component is referred to as being "coupled" to another component, it can be directly attached to the other component or intervening components may be present therebetween.

**Claims**

1. A micro-truss structure (200), comprising:
   a plurality of unit cells (201) arranged in a staggered array, wherein:

   each of the plurality of unit cells (201) comprises a plurality of struts (202) interconnected at a node (204), adjacent ones of at least two of the plurality of unit cells (201) are spaced apart by a gap (207), the plurality of unit cells (201) comprises a first plurality of unit cells (201) arranged in a first row (206) of the array and a second plurality of unit cells (201) arranged in a second row (208) of the array, the second plurality of unit cells (201) in the second row (208) of the array is laterally offset from the first plurality of unit cells (201) in the first row (206) of the array, at least one of the struts (202) in each of the first plurality of unit cells (201) in the first row (206) is interconnected to one of the struts (202) in one of the second plurality of unit cells (201) in the second row (208), and the micro-truss structure (200) has a sparsity of about 3.

2. The micro-truss structure of claim 1, wherein a plurality of the struts (202) is hollow.

3. The micro-truss structure of any one of the preceding claims, wherein the plurality of struts (202) in each of the unit cells (201) is arranged in a square base pyramid configuration or a triangular base pyramid configuration.

4. The micro-truss structure of any one of the preceding claims, further comprising:

   a first facesheet coupled to the node (204) of each of the plurality of unit cells (201); and
   a second facesheet coupled to ends of the plurality of struts (202).

5. The micro-truss structure of any one of the preceding claims, wherein each of the plurality of unit cells (201) is a full unit cell or a half unit cell.

6. The micro-truss structure of any one of the preceding claims, wherein at least one of a length of the struts (202), a diameter of the struts (202), a spacing between the nodes (204), and a height of the unit cells (201) varies across the micro-truss structure.

7. A method of manufacturing the micro-truss structure (200) of claim 1, the method comprising:

irradiating a volume of photo-monomer (309) with a plurality of light beams (310) to form the plurality of unit cells arranged in the array, wherein each of the plurality of unit cells (201) comprises a plurality of polymer optical waveguides (312) interconnected at a node.

8. The method of claim 7, wherein the plurality of light beams (310) are directed through a plurality of apertures (308) defined in a mask (307), and wherein the plurality of apertures (308) in the mask (307) are arranged in either an aligned array or a staggered array.

9. The method of claim 7 or claim 8, further comprising:

coupling a first facesheet to the node of each of the plurality of unit cells; and
coupling a second facesheet to ends of the plurality of polymer optical waveguides (312).

10. The method of any one of claims 7-9, further comprising coating the polymer optical waveguides (312) with a dissimilar material by a process selected from the group of processes consisting of electrodeposition, electroplating, vapor deposition, spray coating, dip coating, and combinations thereof.

11. The method of any one of claims 7-10, comprising selectively removing the polymer optical waveguides (312) to form a plurality of interconnected hollow tubular struts formed out of the dissimilar material coated onto the polymer optical waveguides (312).

**Patentansprüche**

1. Mikrofachwerkstruktur (200), umfassend:
eine Mehrzahl von Einheitzellen (201), die in einer gegeneinander versetzten Anordnung angeordnet sind, wobei:

jede der Mehrzahl von Einheitzellen (201) eine Mehrzahl von Streben (202) umfasst, die an einem Knoten (204) miteinander verbunden sind,
benachbarte Zellen von mindestens zwei der Mehrzahl von Einheitzellen (201) durch einen Spalt (207) voneinander beabstandet sind,
die Mehrzahl der Einheitzellen (201) eine erste Mehrzahl von Einheitzellen (201) umfasst, die in einer ersten Reihe (206) der Anordnung angeordnet sind, und eine zweite Mehrzahl von Einheitzellen (201), die in einer zweiten Reihe (208) der Anordnung angeordnet sind,
die zweite Mehrzahl der Einheitzellen (201) in der zweiten Reihe (208) der Anordnung lateral von der ersten Mehrzahl von Einheitzellen (201) in der ersten Reihe (206) der Anordnung versetzt ist,
mindestens eine der Streben (202) in jeder der ersten Mehrzahl der Einheitzellen (201) in der ersten Reihe (206) mit einer der Streben (202) in einer der zweiten Mehrzahl von Einheitzellen (201) in der zweiten Reihe (208) verbunden ist, und
die Mikrofachwerkstruktur (200) eine Spärlichkeit von etwa 3 aufweist.

2. Mikrofachwerkstruktur nach Anspruch 1, wobei eine Mehrzahl der Streben (202) hohl ist.

3. Mikrofachwerkstruktur nach einem der vorstehenden Ansprüche, wobei die Mehrzahl von Streben (202) in jeder der Einheitzellen (201) in einer Pyramidenkonfiguration mit quadratischer Grundfläche oder einer Pyramidenkonfiguration mit dreieckiger Grundfläche angeordnet ist.

4. Mikrofachwerkstruktur nach einem der vorstehenden Ansprüche, ferner umfassend:

ein erstes Oberflächenblatt, das mit dem Knoten (204) jeder der Mehrzahl von Einheitzellen (201) gekoppelt ist; und
ein zweites Oberflächenblatt, das mit Enden der Mehrzahl von Streben (202) gekoppelt ist.

5. Mikrofachwerkstruktur nach einem der vorstehenden Ansprüche, wobei jede der Mehrzahl von Einheitzellen (201) eine volle Einheitzelle oder eine halbe Einheitzelle ist.

6. Mikrofachwerkstruktur nach einem der vorstehenden Ansprüche, wobei mindestens eines von einer Länge der Streben (202), einem Durchmesser der Streben (202), einem Abstand zwischen den Knoten (204) und einer Höhe der Einheitzellen (201) über die Mikrofachwerkstruktur hinweg variiert.

7. Verfahren zur Herstellung der Mikrofachwerkstruktur (200) nach Anspruch 1, wobei das Verfahren umfasst: Bestrahlen eines Volumens von Photomonomer (309) mit einer Mehrzahl von Lichtstrahlen (310) zum Bilden der Mehrzahl von Einheitzellen, die in der Anordnung angeordnet sind, wobei jede der Mehrzahl von Einheitzellen (201) eine Mehrzahl von Polymer-Lichtwellenleitern (312) umfasst, die an einem Knoten miteinander verbunden sind.

8. Verfahren nach Anspruch 7, wobei die Mehrzahl von Lichtstrahlen (310) durch eine Mehrzahl von Öffnungen (308), die in einer Maske (307) definiert sind, geleitet wird, und wobei die Mehrzahl von Öffnungen (308) in der Maske (307) entweder in einer ausgerichteten oder einer gegeneinander versetzten Anordnung angeordnet ist.

9. Verfahren nach Anspruch 7 oder Anspruch 8, ferner umfassend:

   Koppeln eines ersten Oberflächenblatts mit dem Knoten jeder der Mehrzahl von Einheitzellen; und
   Koppeln eines zweiten Oberflächenblatts mit Enden der Mehrzahl von Polymer-Lichtwellenleitern (312).

10. Verfahren nach einem der Ansprüche 7 bis 9, ferner umfassend ein Beschichten der Polymer-Lichtwellenleiter (312) mit einem verschiedenen Material durch einen Prozess, der aus der Gruppe von Prozessen ausgewählt wird, die aus Elektroabscheidung, Elektroplattieren, Dampfabscheidung, Sprühbeschichtung, Tauchbeschichtung und Kombinationen davon besteht.

11. Verfahren nach einem der Ansprüche 7 bis 10, umfassend ein selektives Entfernen der Polymer-Lichtwellenleiter (312) zum Bilden einer Mehrzahl von miteinander verbundenen hohlen röhrenförmigen Streben, die aus dem verschiedenen Material gebildet werden, das auf die Polymer-Lichtwellenleiter (312) beschichtet ist.

**Revendications**

1. Structure en micro-treillis (200), comprenant :
   une pluralité de cellules unitaires (201) agencées en réseau en quinconce, où :

   chaque cellule de la pluralité de cellules unitaires (201) comprend une pluralité d'entretoises (202) reliées entre elles par un nœud (204),
   des cellules adjacentes parmi au moins deux cellules de la pluralité de cellules unitaires (201) sont séparées par un espace (207),
   la pluralité de cellules unitaires (201) se compose d'une première pluralité de cellules unitaires (201) agencées en une première rangée (206) du réseau et d'une deuxième pluralité de cellules unitaires (201) agencées en une deuxième rangée (208) du réseau,
   la deuxième pluralité de cellules unitaires (201) dans la deuxième rangée (208) du réseau est décalée latéralement par rapport à la première pluralité de cellules unitaires (201) dans la première rangée (206) du réseau,
   au moins une des entretoises (202) dans chaque cellule de la première pluralité de cellules unitaires (201) dans la première rangée (206) est reliée à une des entretoises (202) dans une cellule de la deuxième pluralité de cellules unitaires (201) dans la deuxième rangée (208), et où
   ladite structure en micro-treillis (200) a une parcimonie de 3 environ.

2. Structure en micro-treillis selon la revendication 1, où une pluralité d'entretoises (202) sont creuses.

3. Structure en micro-treillis selon l'une des revendications précédentes, où la pluralité d'entretoises (202) dans chacune des cellules unitaires (201) est agencée en configuration pyramidale à base carrée ou en configuration pyramidale à base triangulaire.

4. Structure en micro-treillis selon l'une des revendications précédentes, comprenant en outre :

   une première feuille protectrice raccordée au nœud (204) de chaque cellule de la pluralité de cellules unitaires (201) ; et
   une deuxième feuille protectrice raccordée aux extrémités de la pluralité d'entretoises (202).

5. Structure en micro-treillis selon l'une des revendications précédentes, où chaque cellule de la pluralité de cellules unitaires (201) est une cellule unitaire entière ou une demi-cellule unitaire.

6. Structure en micro-treillis selon l'une des revendications précédentes, où une longueur d'entretoise (202) et/ou un diamètre d'entretoise (202) et/ou un espacement entre les nœuds (204) et/ou une hauteur des cellules unitaires (201) varient dans la structure en micro-treillis.

7. Procédé de fabrication de la structure en micro-treillis (200) selon la revendication 1, ledit procédé comprenant : l'irradiation d'un volume de monomère photo-réactif (309) par une pluralité de faisceaux lumineux (310) pour former la pluralité de cellules unitaires agencées en réseau, chaque cellule de la pluralité de cellules unitaires (201) comprenant une pluralité de guides d'ondes optiques polymères (312) reliés entre eux par un nœud.

8. Procédé selon la revendication 7, où la pluralité de faisceaux lumineux (310) passe par une pluralité d'ouvertures (308) définies dans un masque (307), et où la pluralité d'ouvertures (308) dans le masque (307) est agencée en réseau aligné ou en réseau en quinconce.

9. Procédé selon la revendication 7 ou la revendication 8, comprenant en outre :

le raccordement d'une première feuille protectrice au nœud de chaque cellule de la pluralité de cellules unitaires ; et
le raccordement d'une deuxième feuille protectrice aux extrémités de la pluralité de guides d'ondes optiques polymères (312).

10. Procédé selon l'une des revendications 7 à 9, comprenant en outre le revêtement des guides d'ondes optiques polymères (312) avec des matériaux différents, au moyen d'un processus sélectionné dans le groupe de processus comprenant dépôt électrolytique, galvanoplastie, dépôt en phase vapeur, revêtement par pulvérisation, revêtement au trempé et des combinaisons de ceux-ci.

11. Procédé selon l'une des revendications 7 à 10, comprenant le retrait sélectif des guides d'ondes optiques polymères (312) pour constituer une pluralité d'entretoises tubulaires creuses reliées entre elles, formées à partir des matériaux différents revêtus sur les guides d'ondes optiques polymères (312).

## FIG.1A

## FIG.1B

## FIG.2A

## FIG.2B

FIG.3

EP 3 341 322 B1

FIG.4

*FIG.5A*

*FIG.5B*

*FIG.5C*

FIG.6

400

401

FIG.7

500

501

EP 3 341 322 B1

REFERENCES CITED IN THE DESCRIPTION

**Patent documents cited in the description**

- US 2015017383 A1
- WO 2008078883 A1
- US 2010236759 A1
- US 8017193 B
- US 7653279 B
- US 7382959 B
- US 46184114